# EUROPÄISCHE PATENTANMELDUNG

(11) **EP 1 612 528 A2**
(43) Veröffentlichungstag der Anmeldung: **04.01.2006**
(21) Anmeldenummer: 05103854.5
(22) Anmeldetag: 10.05.2005
(51) Int. Cl.: G01J 5/12

(54) **Mikrostrukturierter Infrarot-Sensor und ein Verfahren zu seiner Herstellung**

(30) Priorität: 24.06.2004 DE 102004030418
(71) Anmelder: ROBERT BOSCH GMBH, 70442 Stuttgart (DE)
(72) Erfinder: Kummer, Nils, 71642, Ludwigsburg (DE); Müller-Fiedler, Roland, 71229, Leonberg (DE); Finkbeiner, Stefan, 72810, Gomaringen (DE); Mueller, Andre, 70839, Gerlingen (DE); Muenzel, Horst, 72770, Reutlingen (DE); Maurer, Dieter, 72793, Pfullingen (DE); Hiemer, Stefan, 93437, Furth im Wald (DE); Perthold, Jürgen, 71706, Markgröningen (DE)

(57) **Zusammenfassung**

Die Erfindung betrifft einen mikrostrukturierter Infrarot-Sensor (6) mit mindestens:
einem Sensorchip (9), der eine Membran (12), eine unterhalb der Membran ausgebildete Kaverne (14), eine auf der Membran (12) ausgebildete Thermopile-Struktur (17) mit kontaktierten Leiterbahnen (19, 20) und eine auf der Thermopile-Struktur (17) ausgebildete Absorberschicht (21) zur Absorbtion von Infrarot-Strahlung (IR) aufweist, und
einem auf dem Sensorchip (9) befestigten Kappenchip (11), wobei zwischen dem Kappenchip (11) und dem Sensorchip (9) ein Sensorraum (23) ausgebildet ist, in dem die Thermopile-Struktur (17) aufgenommen ist,
wobei der Infrarot-Sensor (6) einen konvex gewölbten Linsenbereich (24) zur Bündelung einfallender Infrarotstrahlung (IR) auf die Absorberschicht (21) aufweist.

Hierbei kann der Linsenbereich (24) auf der Oberseite des Kappenchips (11) oder eines auf dem Kappenchip (11) befestigten Linsenchips ausgebildet sein.

Der Linsenbereich (24) kann durch Trocknen eines dispensten Lacktröpfchens oder eines aufgeweichten, strukturierten Lackzylinders oder durch nachträgliches Ätzen des getrockneten Lachtröpfchens und des umgebenden Substratmaterials ausgebildet werden.

## Beschreibung

Die Erfindung betrifft einen mikrostrukturierten Infrarot-Sensor und ein Verfahren zu seiner Herstellung.

Derartige Infrarot-Sensoren können insbesondere in Gasdetektoren verwendet werden, bei denen von einer Strahlungsquelle, z. B. einer im Niederstrombereich betriebenen Glühbirne oder einer IR-LED, ausgesandte IR-Strahlung über eine Messstrecke ausgesandt und nachfolgend von dem Infrarot-Sensor aufgenommen wird, und aus der Absorption der Infrarotstrahlung in spezifischen Wellenlängenbereichen auf die Konzentration zu detektierender Gase in der Messstrecke geschlossen werden kann. Derartige Gassensoren können insbesondere im Automobilbereich z. B. zur Detektion eines Lecks in einer mit CO₂ betriebenen Klimaanlage oder zur Untersuchung der Luftqualität der Raumluft verwendet werden.

Die mikrostrukturierten Infrarot-Sensoren weisen im Allgemeinen als Substrat einen Sensorchip auf, in dem eine Membran ausgebildet ist, die von einer Kaverne unterätzt ist. Auf der Membran ist mindestens eine Thermopile-Struktur aus zwei kontaktierten Leiterbahnen aus unterschiedlichen leitfähigen Materialien, z. B. polykristallinem Silizium und einem Metall ausgebildet und eine Absorberschicht zur Absorption der einfallenden IR-Strahlung abgeschieden. Die einfallende IR-Strahlung wird von der Absorberschicht absorbiert, worauf hin sich diese entsprechend der Intensität der absorbierten Strahlung erwärmt. Die aus der Temperaturerhöhung resultierende Thermospannung der kontaktierten Leiterbahnen wird als Messsignal ausgelesen. Auf dem Sensorchip ist im Allgemeinen ein Kappenchip vakuumdicht befestigt, wodurch ein nach Außen abgeschirmter Sensorraum für die Thermopile-Struktur ausgebildet wird. Der Sensor kann hierbei in einem Gehäuse mit aufgesetztem Deckel mit einer Blende zum Durchlassen von IR-Strahlung aufgenommen sein. Zu detektierende IR-Strahlung fällt somit durch die Blende des Deckels und den für IR-Strahlung transparenten Kappenchip aus Silizium im wesentlichen vertikal auf die Absorberschicht. Die Blende hat hierbei in etwa denselben Durchmesser wie die darunter liegende Absorberschicht.

Um eine hinreichende Empfindlichkeit zur Detektion der Gaskonzentration zu erreichen, wird im Allgemeinen ein relativ großer Thermopile-Detektor mit einer großen Anzahl von Thermopiles bzw. Leiterbahnen ausgebildet. Diese können z. B. kreuzförmig von der Membran zu dem umgebenden Substratmaterial geführt werden.

Aufgrund des großen Flächenbedarfs und der komplexen Ausbildung der großen Thermopile-Strukturen ergeben sich hohe Herstellungskosten des Infrarot-Sensors sowie des aus dem Sensor, dem Gehäuse und dem Deckel gebildeten Sensormoduls.

Der erfindungsgemäße Infrarot-Sensor und das Verfahren zu seiner Herstellung weisen demgegenüber insbesondere den Vorteil auf, dass eine hohe Empfindlichkeit bei relativ geringen Herstellungskosten möglich ist.

Der Erfindung liegt der Gedanke zu Grunde, die einfallende IR-Strahlung durch eine Sammel-Linse bzw. konvexe Linse auf die Absorberschicht zu bündeln. Die Sammel-Linse wird hierbei auf der Oberseite des Sensors, d. h. auf der Oberseite des Kappenchips bzw. eines zusätzlich auf dem Kappenchip befestigten Linsenchips ausgebildet, so dass keine zusätzlich aufwendige Anbringung und Justierung optischer Hilfsmittel erforderlich ist.

Aufgrund der erhöhten Empfindlichkeit kann die Anzahl der Thermopiles bzw. Leiterbahnen reduziert werden. Erfindungsgemäß kann weiterhin auch die laterale Ausdehnung der Membran und der Absorberschicht verringert werden.

Der Erfindung liegt hierbei die Erkenntnis zu Grunde, dass auch bei einer Bündelung der Strahlung durch eine Sammel-Linse auf die Absorberschicht ein der Strahlung proportionales Messsignal gewonnen werden kann. Hierbei kann erfindungsgemäß die Fläche der Blende um ein vielfaches größer als üblicherweise verwendete Blenden gewählt werden. Die Sammel-Linse wird durch den konvexen Linsenbereich auf der Oberseite des Kappenchips oder des zusätzlichen Linsenchips und die z. B. plane Unterseite des Kappenchips gebildet, d. h. insbesondere als Konvex-plane Sammellinse. Die optische Bündelung kann hierbei aufgrund der Brechzahlunterschiede der im Gehäuseinnenraum vorhandenen Luft gegenüber dem Halbleitermaterial des Kappenchips oder des zusätzlichen Linsenchips sowie dem Brechzahlunterschied des Halbleitermaterials gegenüber dem Vakuum des Sensorraums erreicht werden.

Erfindungsgemäß kann die Anzahl der Thermopiles dahingehend reduziert werden, dass sie lediglich zu einer Seite von der Membran weggeführt werden.

Der konvexe Linsenbereich auf der Oberfläche des Sensors kann erfindungsgemäß zum einen als getrocknete Lackschicht ausgebildet werden. Hierbei wird eine flüssige Kugelkappe eines optisch transparenten Lackes der Oberfläche ausgebildet, die aufgrund der Oberflächenspannung der Flüssigkeit und der Benetzung der Oberfläche eine konvexe Form mit der gewünschten strahlungsbündelnden Wirkung ausbildet. Durch nachfolgendes Trocknen kann somit eine feste Kugelkappe als konvexer Linsenbereich ausgebildet werden.

Das Lacktröpfchen kann zum einen ausgebildet werden, indem zunächst eine großflächigere Lackschicht aufgetragen und ein Zylinderbereich strukturiert wird, der nachfolgend durch Eindampfen eines Lösungsmittels verflüssigt wird.

Alternativ hierzu kann direkt ein flüssiges Lacktröpfchen dispenst werden, z. B. über einen Kolbendispensers mit Präzisionsnadel. Hierbei treten Zeit- und Materialersparnisse gegenüber der Ausbildung und Strukturierung der Lackschicht und Eindampfung von Lösungsmitteln auf. Die Vorteile der Verwendung eines Kolbendispensers sind insbesondere, dass Änderungen in Druck und Viskosität keine Auswirkungen auf das dispenste Volumen haben. Weiterhin sind sehr kleine Volumen dosierbar, die volumetrische Reproduzierbarkeit ist hoch (z.B. +/- 2%), niederviskose Materialien fließen nicht nach und das Material wird durch Scherung nicht verändert.

Gegenüber Fotolithographien bzw. Sonderlithographien entfällt beim direkten Dispensen insbesondere das Aufschleudern und der Preback- Schritt der ersten Schicht, das Aufschleudern und der Preback-Schritt der zweiten Schicht, die Randentlackung, der Belichtungsvorgang, der nachfolgende Entwicklungsvorgang sowie die erforderliche Lackhöhenkontrolle. Auch der Schritt des Dispensens ist mit z.B. 10 Minuten deutlich kürzer als der bei der Sonderlithographie erforderliche Quellprozess von 45 Minuten, die Trocknung ist erfindungsgemäß mit z.B. 2 Stunden ebenfalls etwas geringer als die bei einer Sonderlithographie erforderliche Trocknung von z.B. 3 Stunden. Es kann hierbei eine Reduzierung der Zeit für den Gesamtprozess um z.B. 60 % und einer Reduktion der Zeit für das Handling durch die Mitarbeiter sogar um über 80 % erreicht werden.

Weiterhin werden beim direkten Dispensen geringere Mengen an Materialien verbraucht, da der bei Auftragen von Schichten und nachfolgendem Strukturierung erforderliche Überschuss nicht auftritt. Auch sind kein Entwickler, kein Lösemittel für den Quellvorgang und keine Fotomaske erforderlich, so dass auch eine erhebliche Materialersparnis erreicht werden kann.

Weiterhin kann der konvexe Linsenbereich auch in dem Substrat selbst, d. h. in dem Kappenchip oder zusätzlichen Linsenchip ausgebildet werden. Hierbei wird gemäß der obigen Ausbildungsformen zunächst eine Kugelkappe aus getrocknetem Lack ausgebildet und nachfolgend die Kugelkappe aus Lack und das umgebende Substratmaterial geätzt, z. B. trockengeätzt. Die Form der sich im Substrat ergebenden Linse entspricht bei der Wahl der Ätzselektivität des Substratmaterials und des Lackes von 1:1 genau der Form der ursprünglichen Lackkugelkappe; durch Variation der Ätzselektivität während des Ätzprozesses kann auch im Substrat eine asphärische Form erzeugt werden, so dass grundsätzlich die Ausbildung komplexerer Geometrien möglich ist.

Die Erfindung wird im Folgenden anhand der beiliegenden Zeichnungen an einigen Ausführungsformen erläutert. Es zeigen:
- Fig. 1: einen Vertikalschnitt durch einen Infrarot-Sensor gemäß einer Ausführungsform der Erfindung;
- Fig. 2: eine Draufsicht auf den Sensorchip im Bereich der Membran;
- Fig. 3 a bis c: die Herstellung des Kappenchips des Sensors der Fig. 1 gemäß einer Ausführungsform;
- Fig. 4 a bis d: die Herstellung einer Linse auf dem Kappenchip gemäß einer zu Fig. 3 alternativen Ausführungsform;
- Fig. 5: einen Kolbendispensor zur Durchführung des in Fig. 4 gezeigten Verfahrens;
- Fig. 6: einen Vertikalschnitt durch einen Infrarot-Sensor einer zu Fig. 1 alternativen Ausführungsform.

Ein Infrarot-Sensormodul 1 weist ein Gehäuse 2 aus z.B. Moldcompound oder Keramik und einen auf dem Gehäuse 2 befestigten Deckel 3 mit einer Blende 4 auf. In dem von dem Gehäuse 2 und dem Deckel 3 eingeschlossenen Gehäuseinnenraum 5 ist ein Infrarot-Sensor 6 aufgenommen. Er weist einen auf den Boden des Gehäuses 2 aufgeklebten Sensorchip 9 und einen auf dem Sensorchip 9 in einer Sealglas-Verbindung 10 befestigten Kappenchip 11 auf. Auf dem Sensorchip 9 ist eine Membran 12 oberhalb einer Kaverne 14 ausgebildet. Die Membran 12 und die Kaverne 14 können z.B. in an sich bekannter Weise durch Ausbilden oder Abscheiden einer SIO2- oder SI3N4-Schicht auf dem Substrat des Sensorchips 9, Strukturieren von Ätzöffnungen, Ätzen der Kaverne14 unterhalb der Schicht und nachfolgendem Verschließen der Ätzöffnungen ausgebildet werden.

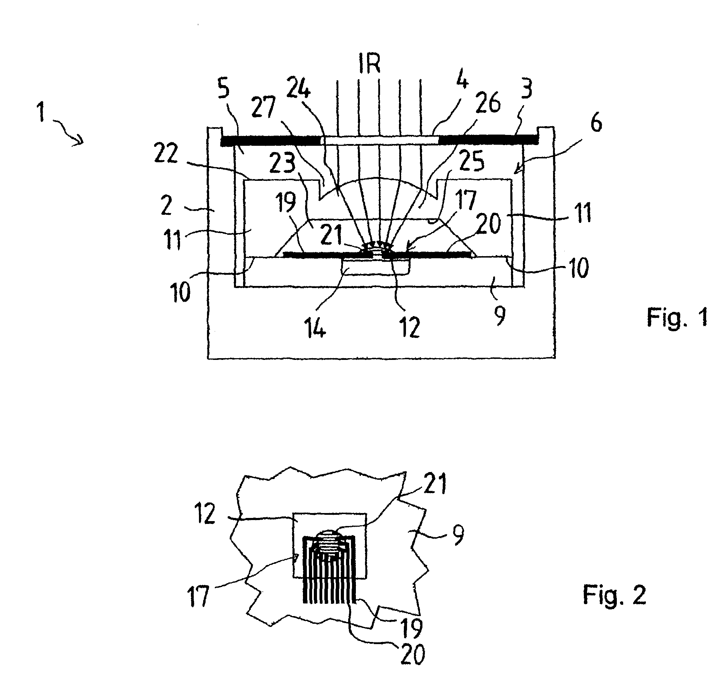

Alternativ zu der gezeigten Ausführungsform kann eine Kaverne 14 von der Unterseite des Sensorchips 9 durch z.B. KOH-Ätzen ausgebildet werden und der Ätzvorgang gestoppt werden, wenn an der Oberseite bzw. Vorderseite des Substrates 9 die hinreichend dünne Membran 12 ausgebildet ist. Bei dieser Ausbildung erstreckt sich die Kaverne 14 abweichend von der Darstellung der Fig. 1 bis zur Unterseite des Sensorchips 9.

Auf der Membran 12 wird in an sich bekannter Weise mindestens eine Thermopile-Struktur 17 abgeschieden, die miteinander kontaktierte Leiterbahnen 19 und 20 aus unterschiedlichen, elektrisch leitfähigen Materialien aufweist, z.B. aus polykristallinem Silizium und aus Aluminium oder einem anderen Metall. Die mindestens eine Thermopile-Struktur 17 ist derartig ausgebildet, dass der "warme Kontaktbereich" der Leiterbahnen 19 und 20 auf der Membran 12 liegt und der "kalte Kontaktbereich" außerhalb der Membran 12 auf dem Substrat 9 aus Silizium liegt. Auf dem Kontaktbereich der Leiterbahnen 19, 20 auf der Membran 12 ist eine Infrarot-Absorbersicht 21 aufgetragen, die sich bei einfallender IR-Strahlung erwärmt, wobei die Temperaturerhöhung eine Thermospannung an den Leiterbahnen 19, 20 bewirkt, die als elektrisches Signal ausgelesen werden kann.

Zwischen dem Kappenchip 11 und dem Sensorchip 9 ist ein Sensorraum 23 ausgebildet, in dem ein durch die Sealglas-Verbindungsbereiche 10 gegenüber dem Gehäuseinnenraum 5 isoliertes Vakuum ausgebildet ist. Hierzu ist an der Unterseite des Kappenchips 11 eine Kaverne z.B. durch KOH-Ätzen ausgebildet, die bei Befestigung des Kappenchips 11 auf dem Sensorchip 9 in den Sealglas-Verbindungsbereichen 10 den Sensorraum 23 bildet. Auf der Oberseite 22 des Kappenchips 11 ist in einem Bereich oberhalb der Thermopile-Struktur 17 ein konvexer Linsenbereich 24 ausgebildet, der vorteilhafterweise sphärisch gekrümmt ist. Der konvexe Linsenbereich 24 aus Silizium ist bei dieser Ausführungsform in einer Vertiefung 27 der Oberseite 22 ausgebildet und grenzt an den z.B. mit Luft, einem Schutzgas oder Vakuum gefüllten Gehäuseinnenraum 5 an. An seiner Unterseite weist er eine an den unter Vakuum stehenden Sensorraum 23 angrenzende plane Grenzfläche 25 auf und wirkt somit als konvex-plane Sammellinse 26, die von außerhalb durch die Blende 4 in den Gehäuseinnenraum 5 einfallende IR-Strahlung IR auf die Absorberschicht 21 bündelt. Der Brennpunkt der IR-Strahlung liegt hierbei vorteilhafterweise als breiter Fleck in der Absorberschicht 21.

Alternativ zu der gezeigten Ausführungsform mit einer konvex-planen Sammellinse 24 kann entsprechend auch eine bikonvexe Sammellinse oder eine Sammellinse als Struktur aus mehreren konvexen, lateral nebeneinander liegenden Bereichen ausgebildet werden. Weiterhin kann grundsätzlich auch anstelle der Sammellinse als strahlenbündelnde Einrichtung eine prismaartige Struktur mit einer nach oben weisenden Spitze und schräg abfallenden planen Flächen ausgebildet sein. Relevant ist hierbei, dass die einfallende IR-Strahlung durch die strahlenbündelnde Einrichtung auf die Absorberschicht 21 gebündelt bzw. fokussiert wird. Der Brennpunkt bzw. - Fleck liegt vorteilhafterweise in der Absorberschicht 12.

Die Fläche der Blende 4 ist erfindungsgemäß deutlich größer als die Fläche der Absorberschicht 21, z.B. um das 2-1 0fache größer. Hierdurch fällt auf die Sammellinse 26 um eine Vielfaches mehr IR-Strahlung als ohne Verwendung einer derartigen strahlungsbündelnden Einrichtung, wobei die IR-Strahlung auf die Absorberschicht 21 gebündelt wird. Die zum Lichteinfall proportional erhöhte, in die Absorberschicht 21 eingeleitete Wärme ergibt eine proportionale Erhöhung der Empfindlichkeit bei einer gleich bleibenden Anzahl von Thermopile-Strukturen 17.

Falls eine gleich bleibende Empfindlichkeit des IR-Sensors 6 gegenüber einem ohne Verwendung einer Sammellinse 26 ausgebildeten IR-Sensor angestrebt wird, kann die Anzahl der Thermopile-Strukturen 17 proportional reduziert werden, wodurch entsprechend die Abmessung der Thermopile-Strukturen 17 und des Sensorchips 9 reduziert werden kann.

Fig. 2 zeigt eine Draufsicht auf die Membran 12 mit mehreren Thermopile-Strukturen 17 mit jeweils kontaktieren Leiterbahnen 19, 20. Sie können erfindungsgemäß - anstelle derzeit üblicher kreuzweise Ausbildungen zu allen Seiten hin - lediglich in einer Richtung, in Fig. 2 nach unten, weggeführt werden.

Bei allen gezeigten Ausführungsformen kann der IR-Sensor 6 bereits auf Wafer-Ebene ausgebildet werden. Hierzu werden in einem Sensor-Wafer mehrere Membranen 12, Kavernen 14 und Thermopile-Strukturen 17 ausgebildet und in einem Kappen-Wafer auf der Oberseite mehrere konvexe Linsenbereiche 24 und an der Unterseite Kavernen für die Sensorräume 23 ausgebildet. Weiterhin wird Sealglas, d.h. ein niedrig schmelzendes Bleiglas, auf dem Sensor-Wafer um die Thermopile-Strukturen 17 herum aufgetragen und der Kappen-Wafer positionsgenau auf dem Sensor-Wafer angebracht. Durch Erhitzen bzw. Backen des so gebildeten Wafer-Stapels mit nachfolgendem Vereinzeln werden dann die einzelnen IR-Sensoren 6 kostengünstig gefertigt.

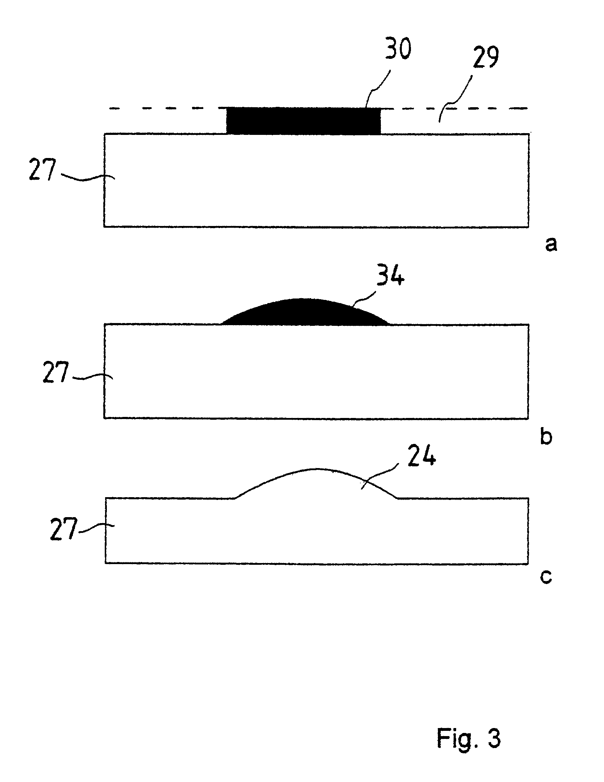

Die Figur 3 a bis c zeigt eine Ausführungsform eines derartigen erfindungsgemäßen Herstellungsprozesses auf Waferebene, d.h. vor dem Vereinzeln. Hierzu wird auf dem Kappensubstrat bzw. Kappen-Wafer 27 eine lichtempfindliche Lackschicht 29 aufgebracht und fotolithographisch zu einem Zylinder 30 strukturiert.

Anschließend wird der Lack des Zylinders 30 bei einer geeigneten Temperatur von 60° C bis 80° C, z.B. 75° C unter Zugabe von Lösungsmitteldampf, z.B. Aceton-Dampf, über 25 Minuten verflüssigt. Der verflüssigte Lack bildet gemäß Fig. 3 b aufgrund seiner Benetzungseigenschaften und unter Einfluss der Schwerkraft und der Oberflächenspannungen eine flüssige Kugelkappe 34 und wird gemäß Fig. 3 c anschließend bei hoher Temperatur von z.B. T= 100° bis 120° C wieder ausgehärtet zu einer festen Kugelkappe. Grundsätzlich ist es auch möglich, den Zylinder 30 durch Temperaturerhöhung bei T= 150° bis 160° C ohne Zufuhr von Lösungsmitteldämpfen aufzuschmelzen und anschließend erstarren zu lassen. Durch das Eindampfen des Lösungsmittels und nachfolgende Aushärten werden jedoch die Veränderungen des Lackes während eines Schmelzvorganges vermieden, bei dem Lösungsmittel ausdiffundiert und der Lack somit seine chemische Konsistenz verändert. Insbesondere werden die durch Ausdampfen des Lösungsmittels möglichen Abweichungen von der angestrebten Sollstruktur und die hieraus resultierenden Abbildungsfehler, die die Funktion der optischen Systeme beeinflussen können, vermieden oder zumindest weitgehend vermieden.

In einer Trockenätzanlage werden die getrocknete, feste Kugelkappe 34 aus Lack und das umgebende Silizium des Kappen-Wafers 27 geätzt, so dass sich die Lackform in das Silizium des Kappen-Wafers 27 überträgt und gemäß Fig. 3 c der konvexe Linsenbereich 24 in dem Kappen-Wafer 27 ausgebildet wird . Die Form des sich im Kappen-Wafer 27 ergebenden konvexen Linsenbereichs 24 entspricht bei einer Wahl der Ätzselektivität von Silizium zu Lack von 1:1 genau der Form der ursprünglichen Kugelkappe 34 aus Lack der Fig. 3 b. Durch Variation der Ätzselektivität während des Ätzprozesses kann im Silizium des Kappen-Wafers 27 aber auch eine asphärische Form erzeugt werden.

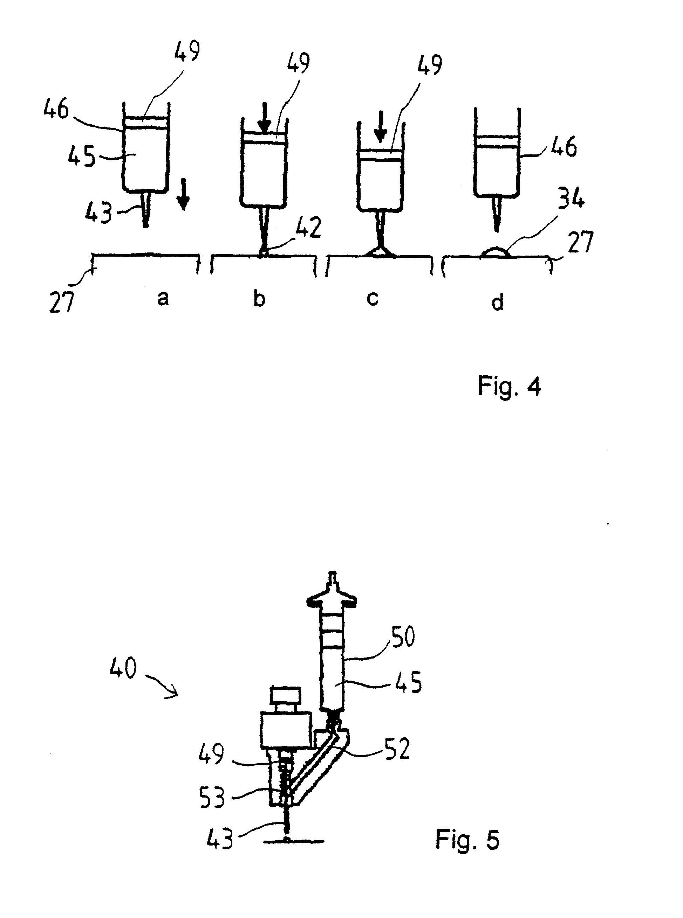

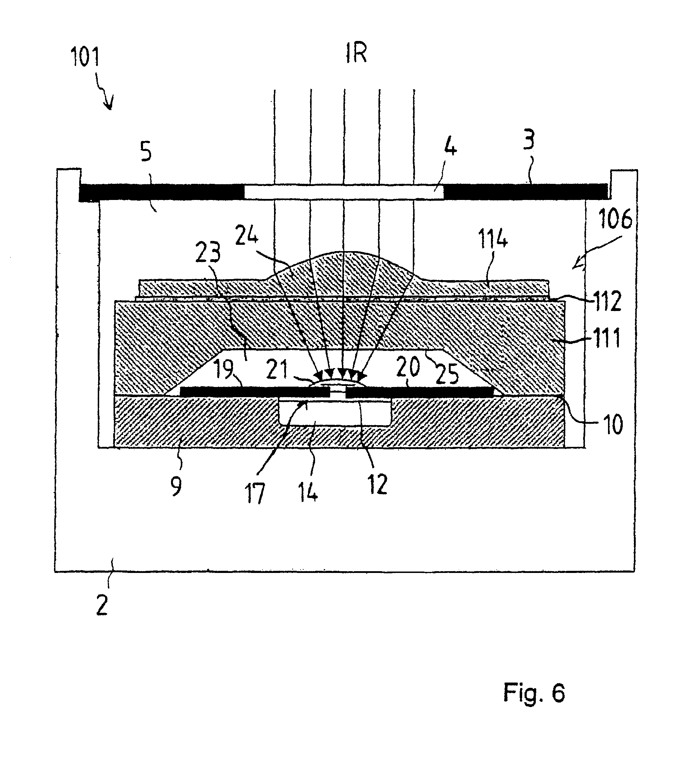

Alternativ zu dem in den Fig. 3 a bis c gezeigten Prozess können gemäß Fig. 4 a bis d auch Kugelkappen 34 aus flüssigem Lack direkt auf dem Kappen-Wafer 27 aufgebracht werden. Hierbei werden diese mittels eines in Fig. 5 beispielhaft detaillierter gezeigten Kolbendispensers 40 kleine Tröpfchen 42 einer Lackflüssigkeit 45 bzw. flüssigen Lackes von einer Präzisions-Nadel 43 auf dem Kappen-Wafer 27 aufgebracht, die nachfolgend aufgrund der Oberflächenspannung die konvexen Kugelkappen 34 bilden. Durch dieses Dispensen bzw. automatisierte Dosieren wird der relativ umfangreiche, zeitaufwändigere und materialintensivere Fotolithographieprozess der Fig. 3 a bis c ersetzt. Auch bei dieser Ausführungsform werden die oben genannten Veränderungen des Lackes während eines Schmelzvorganges vermieden, insbesondere mögliche Abweichungen von der angestrebten Sollstruktur und die hieraus resultierenden Abbildungsfehler weitgehend oder ganz vermieden.

In den Fig. a bis d ist der Kolbendispenser 40 zunächst schematisch dargestellt. Ein mit Lackflüssigkeit 45 gefüllter Zylinder 46 wird zu dem Kappen-Wafer 27 verstellt, bis die Präzisions-Nadel 43 hinreichend nah über diesem ist. Nachfolgend wird durch Herabsenken eines Kolbens 49 ein Tröpfchen 42 der Lackflüssigkeit 45 auf dem Kappen-Wafer 27 abgeschieden. Hierbei kann eine Benetzung der Oberfläche des Kappen-Wafers 27 bereits bei der Ausbildung des Tröpfchens 42 an der Präzisions-Nadel 43 erfolgen, so dass auch sehr kleine Tröpfchen ausgebildet werden können. Gemäß Fig. 4 d wird nachfolgend der Zylinder 46 wieder vertikal entfernt, so dass die zunächst flüssige Kugelkappe 34 aus flüssigem Lack auf dem Kappen-Wafer 27 verbleibt und nachfolgend in dieser Form erhärtet.

Gemäß Fig. 5 kann der Kolbendispenser 40 wie folgt ausgebildet sein: Als Behälter 50 für die Lackflüssigkeit 34 kann z.B. eine Kartusche benutzt werden, wobei die Lackflüssigkeit 45 unter geringem Druck von z.B. 0,3 bis 0,8 bar durch einen Kanal 52 zu einer Pumpkammer 53 geleitet wird. Bewegt sich der Kolben 49 nach oben, veranlasst ein Unterdruck, dass die Lackflüssigkeit 45 in eine Dispenskammer fließt. Wenn sich der Kolben nach unten bewegt, wird die Materialzuführung unterbrochen und der Kolben 49 drückt die gewünschte Menge der Lackflüssigkeit 45 durch die als Präzisions-Nadel 43 ausgebildete Dispenser-Nadel.

Fig. 6 zeigt eine weitere Ausführungsform mit gegenüber der ersten Ausführungsform der Fig. 1 unverändertem Gehäuse 2 und unverändertem Deckel 3, bei der der IR-Sensor 106 gegenüber Fig. 1 auch einen unveränderten Sensorchip 9 mit Membran 12 aufweist. Der Kappenchip 111 weist jedoch eine plan ausgebildete Oberseite auf, auf der über eine Kleberschicht 112 aus optisch transparentem Kleber ein Linsenchip 114 aus Silizium befestigt ist. Der Linsenchip 114 weist auf seiner Oberseite den konvexen Linsenbereich 24 auf. Der konvexe Linsenbereich 24 kann hierbei mit sämtlichen oben beschriebenen Prozessen, insbesondere der Fig. 3 a bis c und 4 a bis d, ausgebildet werden.

Auch die Herstellung des Sensors 106 kann auf Wafer-Ebene erfolgen, indem ein Sensor-Wafer, ein Kappen-Wafer und ein Linsen-Wafer getrennt hergestellt werden, wobei bei dieser Ausführungsform der Kappen-Wafer lediglich von einer Seite her zur Ausbildung des Sensorraums 23 zu strukturieren ist und der Linsen-Wafer entsprechend dem Kappen-Wafer 27 der ersten Ausführungsform ausgebildet wird. Nachfolgend wird ein Wafer-Stapel aus diesen drei Wafern erzeugt, bei dem der Kappen-Wafer in den Sealglas-Verbindungsbereichen 10 auf dem Sensor-Wafer und der Linsen-Wafer in der Kleberschicht 112 auf dem Kappen-Wafer befestigt wird. Alternativ zu der in Fig. 6 gezeigten Ausbildung kann sich der Linsenchip 114 lateral bis zu der Breite des Kappenchips 111 und des Sensorchips 6 erstrecken, so dass die Herstellung als Wafer-Stapel mit nachfolgendem Vereinzeln erleichtert ist.

## Patentansprüche

1. Mikrostrukturierter Infrarot-Sensor (6, 106) mit mindestens:
einem Sensorchip (9), der eine Membran (12), eine unterhalb der Membran (12) ausgebildete Kaverne (14), mindestens eine auf der Membran (12) ausgebildete Thermopile-Struktur (17) mit zwei kontaktierten Leiterbahnen (19, 20) aus unterschiedlichen, elektrisch leitfähigen Materialien und eine auf der Thermopile-Struktur (17) ausgebildete Absorberschicht (21) zur Absorbtion von Infrarot-Strahlung (IR) aufweist,
einem auf dem Sensorchip (9) in vakuumdichten Verbindungsbereichen (10) befestigten Kappenchip (11, 111) wobei zwischen dem Kappenchip (11, 111) und dem Sensorchip (9) ein Sensorraum (23) mit einem Vakuum ausgebildet ist, in dem die Thermopile-Struktur (17) aufgenommen ist,
wobei auf einer Oberseite des Infrarot-Sensors (6, 106) ein konvex gewölbter Linsenbereich (24) zur Bündelung einfallender Infrarotstrahlung (IR) auf die Absorberschicht (21) ausgebildet ist.

2. Infrarot-Sensor nach Anspruch 1, **dadurch gekennzeichnet, dass** der konvex gewölbte Linsenbereich (24) auf der Oberseite (22) des Kappenchips (11) ausgebildet ist.

3. Infrarot-Sensor nach Anspruch 2, **dadurch gekennzeichnet, dass** der konvex gewölbte Linsenbereich (24) in einer Vertiefung (27) der Oberseite (22) des Kappen-Chips (11) ausgebildet ist.

4. Infrarot-Sensor nach Anspruch 1, **dadurch gekennzeichnet, dass** der konvexe Linsenbereich (24) in einem auf dem Kappenchip (111) befestigten Linsenchip (114) ausgebildet ist.

5. Infrarot-Sensor nach Anspruch 4, **dadurch gekennzeichnet, dass** der Linsenchip (114) auf dem Kappenchip (111) mit einer Kleberschicht (112) aus optisch transparentem Kleber befestigt ist.

6. Infrarot-Sensor nach einem der vorherigen Ansprüche, **dadurch gekennzeichnet, dass** der Linsensbereich (24) im Wesentlichen sphärisch gewölbt ausgebildet ist.

7. Infrarot-Sensor nach einem der vorherigen Ansprüche, **dadurch gekennzeichnet, dass** eine Sammellinse (26) aus dem konvexen Linsenbereich (24) und einer Unterseite (25) gebildet wird und der Brennpunkt der Sammellinse (26) in der Absorberschicht (21) liegt.

8. Infrarot-Sensor, nach einem der vorherigen Ansprüche, **dadurch gekennzeichnet, dass** der konvexe Linsensbereich (24) als eine Kappe (34) aus erstarrtem, aufgetragenen, für die IR-Strahlung transparentem Lack ausgebildet ist.

9. Infrarot-Sensor nach Anspruch 8, **dadurch gekennzeichnet, dass** der transparente Lack ein Fotolack ist.

10. Infrarot-Sensor nach einem der Ansprüche 1 bis 7, **dadurch gekennzeichnet, dass** der konvexe Linsenbereich (24) in dem Substratmaterial des Kappenchips (11) oder Linsenchips (114) ausgebildet ist.

11. Infrarot-Sensor nach einem der vorherigen Ansprüche, **dadurch gekennzeichnet, dass** der laterale Durchmesser des konvexen Linsenbereiches (24) größer als der laterale Durchmesser der Absorberschicht (21) ist.

12. Infrarot-Sensor nach einem der vorherigen Ansprüche, **dadurch gekennzeichnet, dass** die Leiterbahnen (19, 20) der Thermopile-Struktur (17) zu einer Seite der Membran (12) weggeführt sind.

13. Sensormodul (1, 101), das aufweist:
ein Gehäuse (2),
einen auf dem Gehäuse (2) befestigten Deckel (3) mit einer Blende (4) zum Durchlassen von Infrarot-Strahlung (IR), und
einen zwischen dem Gehäuse (2) und dem Deckel (3) ausgebildeten Gehäuseinnenraum (5),
einen Infrarot-Sensor (6, 106) nach einem der Ansprüche 1 bis 12, der auf dem Gehäuse (2) in dem Gehäuseinnenraum (5) angebracht ist,
wobei die Blende (4) oberhalb des konvexen Linsenbereichs (24) des Infrarot-Sensors (6, 106) ausgebildet ist.

14. Verfahren zum Herstellen eines Infrarot-Sensors (6, 106), mit mindestens folgenden Schritten:
Ausbilden eines Sensor-Substrates (9) mit mindestens einer Membran (12), einer Thermopile-Struktur (17) und einer auf der Thermopile-Struktur (17) aufgetragenen Absorberschicht (21),
Ausbilden einer flüssigen Kugelkappe (34) aus einem für die zu detektierende IR-Strahlung transparenten Lack auf einem Kappen-Substrat (11, 27, 111) oder einem Linsensubstrat (114),
Erhärten der Kugelkappe (34),
Befestigen des Kappen-Substrates (11, 27, 111) auf einem Sensor-Substrat (9) derartig, dass die Thermopile-Struktur (17) des Sensor-Substrates (9) in einem Sensorraum (23) zwischen dem Kappensubstrat (11, 27, 111) und dem Sensor-Substrat (9) angeordnet ist,
wobei der konvexe Linsenbereich (24) des Kappen-Substrates (11, 27, 111) oder des Linsensubstrates (114) oberhalb der Absorberschicht (21) ausgebildet ist.

15. Verfahren nach Anspruch 14, **dadurch gekennzeichnet, dass** die flüssige Kugelkappe (34) ausgebildet wird, indem ein Tröpfchen (42) einer Lackflüssigkeit (45) mittels einer Präzisions-Nadel (43) auf dem Substrat abgeschieden wird.

16. Verfahren nach Anspruch 15, **dadurch gekennzeichnet, dass** die flüssige Kugelkappe (34) ausgebildet wird, indem
eine Lackschicht (29) aus strahlungstransparentem Lack ausgebildet wird,
ein Zylinder (30) in der Lackschicht (29) strukturiert wird, und
der Zylinder (30) durch Eindämpfen von Lösungsmittel zu der flüssigen Kugelkappe (34) aufgeweicht wird.

17. Verfahren nach einem der Ansprüche 15 bis 17, **dadurch gekennzeichnet, dass** der konvexe Linsenbereich (24) durch die getrocknete Kugelkappe (34) gebildet wird.

18. Verfahren nach einem der Ansprüche 15 bis 17, **dadurch gekennzeichnet, dass** der konvexe Linsenbereich (24) gebildet wird, indem nach Trocknen der flüssigen Kugelkappe (34) das Kappen-Substrat (11, 27) oder das Linsensubstrat (114) geätzt wird derartig, dass die getrocknete Kugelkappe (34) und umliegendes Substratmaterial weggeätzt werden und der konvexe Linsenbereich (24) im Substrat (11, 27, 114) ausgebildet wird.

19. Verfahren nach Anspruch 19, **dadurch gekennzeichnet, dass** die Ätzgeschwindigkeit im getrockneten Fotolack und im umliegenden Substrat (11, 27, 114) im wesentlichen gleich groß sind.

20. Verfahren nach Anspruch 18, **dadurch gekennzeichnet, dass** die Ätzgeschwindigkeit im getrockneten Fotolack gegenüber der Ätzgeschwindigkeit im umliegenden Substrat (11, 27, 114) derartig verschieden ist, dass das Ätzen einer sphärischen getrockneten Kugelkappe (34) zu einem asphärischen konvexen Linsenbereich (24) im Substrat (11, 27, 114) führt.

21. Verfahren nach einem der Ansprüche 14 bis 20, **dadurch gekennzeichnet, dass** der konvexe Linsenbereich (24) auf der Oberseite (22) des Kappensubstrates (11, 27) ausgebildet wird.

22. Verfahren nach einem der Ansprüche 14 bis 20, **dadurch gekennzeichnet, dass** der konvexe Linsenbereich (24) in einem Linsensubstrat (114) ausgebildet wird, der mittels einer strahlungstransparenten Kleberschicht (112) auf der Oberseite des Kappenchips (111) befestigt wird.

23. Verfahren nach einem der Ansprüche 14 bis 22, **dadurch gekennzeichnet, dass** der konvexe Linsensbereich (24) derartig befestigt wird, dass sein Brennpunkt in der Absorberschicht (21) liegt.
